(19)

**Europäisches Patentamt**
**European Patent Office**
**Office européen des brevets**

(11)  **EP 4 168 764 B1**

(12)  **EUROPEAN PATENT SPECIFICATION**

(45) Date of publication and mention
of the grant of the patent:
**18.03.2026   Bulletin 2026/12**

(21) Application number: **21826278.0**

(22) Date of filing: **10.06.2021**

(51) International Patent Classification (IPC):
*G01L 1/18* (2006.01)          *B32B 5/18* (2006.01)
*G01L 1/22* (2006.01)          *B32B 5/24* (2006.01)
*B32B 9/02* (2006.01)          *B32B 27/06* (2006.01)

(52) Cooperative Patent Classification (CPC):
**G01L 1/18; B32B 5/18; B32B 5/245; B32B 9/025;**
**B32B 27/065; G01L 1/2287**

(86) International application number:
**PCT/CN2021/099425**

(87) International publication number:
**WO 2021/254249 (23.12.2021 Gazette 2021/51)**

(54) **PIEZORESISTIVE PRESSURE SENSOR BASED ON FOAM STRUCTURE**

PIEZORESISTIVER DRUCKSENSOR AUF BASIS EINER SCHAUMSTRUKTUR

CAPTEUR DE PRESSION PIÉZORÉSISTIF À STRUCTURE EN MOUSSE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **18.06.2020  EP 20180799**

(43) Date of publication of application:
**26.04.2023   Bulletin 2023/17**

(73) Proprietor: **BASF SE**
**67056 Ludwigshafen am Rhein (DE)**

(72) Inventors:
 • **LEE, Jun Min**
   **Suwon-si, Gyeonggi-do 16342 (KR)**
 • **LIN, Wei Hsiang**
   **Suwon-si, Gyeonggi-do 16342 (KR)**
 • **SCHROEDER, Marc**
   **10245 Berlin (DE)**
 • **MARTIN, Marc**
   **Shanghai 200137 (CN)**
 • **ZHANG, Zhong Kai**
   **Shanghai 200137 (CN)**

 • **LI, Chang Xi**
   **Shanghai 200137 (CN)**
 • **KIM, Min Jung**
   **Suwon-si, Gyeonggi-do 16357 (KR)**
 • **CHO, Ikbin**
    **Seoul 04620 (KR)**

(74) Representative: **BASF IP Association**
**BASF SE**
**Global Intellectual Property**
**GBI, Building Z078**
**Carl-Bosch-Strasse 38**
**67056 Ludwigshafen (DE)**

(56) References cited:
**EP-A1- 0 823 124          EP-B1- 0 823 124**
**WO-A1-99/27550          WO-A2-97/13130**
**WO-A2-97/13130          CN-A- 105 738 015**
**CN-A- 107 107 939          CN-A- 110 579 295**
**DE-A1- 19 750 671          KR-A- 20190 033 259**
**KR-B1- 101 753 247          US-A- 5 060 527**
**US-A1- 2014 215 850          US-A1- 2016 340 534**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**TECHNICAL FIELD**

The present invention belongs to the technical field of pressure sensor, and in particular relates to a piezoresistive pressure sensor and the preparation method thereof. The present invention also relates to a control system and a car horn control system in car steering wheel comprising the same.

**BACKGROUND ART**

Pressure sensors are widely used for detecting pressure. In some situations, it is not only needed to detect the existence of pressure, but also needed to detect the exact position where the pressure is exerted. In order to achieve this function, piezocapacitive pressure sensors, which are generally used, should be arranged into pressure sensor arrays. Commercially available piezocapacitive pressure sensor arrays of thin-film type have a 2D-patterned (two dimensional-patterned) thin-film capacitive material layer and electrode layers attached thereto to form an array. Such a structure, however, could only be obtained through an expensive production process, since the production of 2D-patterned thin-film costs much labor and time. Moreover, such a structure generally has low flexibility.

There are also pressure sensors based on piezoresistive effect. In such pressure sensors, when pressure is exerted on its surface, a change in resistance in proportion to the magnitude of the pressure is produced. Piezoresistive pressure sensor can detect both the existence of pressure and the position where the pressure is exerted without a 2D-patterning of the piezoresistive material layer. However, commercially available piezoresistive pressure sensors generally have limited flexibility and reliability, which make them difficult to combine with soft surface like soft sofa, office chair and artificial leather.

It has been proposed to use polymeric material in pressure sensors to improve the flexibility. For example, US2017/0199095A1 has described a piezocapacitive pressure sensor, in which a foam layer is used between the electrode layers, wherein the foam layer can be made from polymers such as polyurethane. The disclosed pressure sensor is based on the capacitance of the two electrodes and applies polyurethane foam having an average cell size of about 50 to 250 micrometer. Such small cell size is difficult to control and the manufacturing cost is very high, even though it may provide improved sensitivity.

Although commercial polymeric materials can be used in pressure sensors, those polymeric materials, such as artificial leather, have poor translucency (usually less than 3%) and do not have piezoresistive pressure sensing function. Pressure or touch sensing sensor arrays underneath are usually thin film type or capacitance touch functioned display panel with a 2D-patterned thin-film piezoresistive layer structure or more complex vacuum processed thin film device. Owing to those structures, the manufacturing cost is usually expensive. In addition, owing to limited translucency of polymeric materials and carbon black used, thin film pressure sensor and other component for control system and current system are difficult to combine information display, touch sensor or pressure sensor with backlight system underneath. For example, WO2018/013557A1 discloses vehicle interior component comprising a composite structure consisting of a sensor, a display, a cover and a functional layer, wherein the sensor is configured to detect input from the vehicle occupant at the cover; the display is configured to provide illumination visible through the translucent cover. However, the foam used in the composite structure is only for comfort and detection is only on/off control by using display panel.

The pressure sensors can be used in various applications, for examples in car interior, such as car horn system. In current car horn system, the volume control of car horn is usually by on and off mode, which is sometimes too loud to express user's intention. Commercially available car horn system controlled by thin film pressure sensor has rigid surface feeling, which is hard to control/maintain the volume more precisely. For example, US2017/0057409A1 discloses a steering wheel having integrated horn actuator, wherein force-sensing device comprised piezoelectric sensors is installed in the steering wheel, and the user can optionally activate different volume or tones of the horn by setting various threshold conditions. However, the threshold does not have gradual sound level between each threshold. In addition, the application does not mention conductive foam.

US9254786B2 discloses a vehicle horn control assembly, comprising a sensor assembly and a controller. The user can set the sensitivity of the car horn. However, the sensor assembly has a sensory array that includes a plurality of sensor zones being configured to output a respective pressure signal. It's overall vehicle horn control assembly with an algorithm. In addition, the application includes no information about the car horn material or the principle of how to detect the pressure.

It still remains a great challenge to make pressure sensors with large area. For example, current available pressure sensors with foam as top layer with large area usually show low sensitivity, even though such matter may be improved by applying sophisticated algorithm. Therefore, it is still desired to provide pressure sensors which can detect pressure and the exerting position while having sufficient flexibility and reliability, and can be produced by inexpensive processes. Especially, the sensor shall have excellent sensitivity.

Prior art documents relevant to the invention are patent documents EP 0 823 124 A1, WO 99/27550 A1, WO 97/13130 A2, US 2016/340534 A1, and US 2014/215850 A1.

In addition, it is still required to provide new pressure sensors to satisfy various application requirements, such as to replace current control system with poor translucency (less than 3%) for backlight or display integrated system; and to provide new car horn system having sensitivity and reliability, which give user much better experience to control the car horn volume more precisely.

## CONTENT OF THE PRESENT INVENTION

It is an object of the invention to provide a piezoresistive pressure sensor according to claim 1.

Thus, this invention can provide cost-efficient pressure sensor by using cheap and commercially available materials to form piezoresistive material layer and employing cost-efficient fabrication processes like printing and coating.

It is another object of the invention to provide a control system, comprising a piezoresistive pressure sensor, and thus to make the user to control the control system more precisely.

It is another object of the invention to provide a car horn control system in car steering wheel, comprising the piezoresistive pressure sensor, and thus to make the user to control the volume more precisely.

The present invention also provides a process for producing piezoresistive pressure sensor according to claim 16.

The present invention also provides use of a combination layer of an artificial leather layer and a continuous piezoresistive foam layer for producing piezoresistive pressure sensor.

It has been surprisingly found that the conductive materials doped foam layer imparts to the pressure sensor good flexibility and reliability, making it suitable to be combined with soft surfaces. Moreover, the pressure sensor of this invention, owing to the sufficient flexiblility, does not need to have a 2D-patterned piezoresistive structure and therefore can be prepared by a simple lamination at a substantially reduced production cost and can provide overall 2D-pressure mapping in a large area.

In addition, by adopting different types of cover layer and/or piezoresistive material layer with specific properties, such as density, flexibility and translucency, the inventive piezoresistive pressure sensor is especially suitable for car interior, backlight or display integrated system and the like.

## BRIEF DESCRIPTION OF FIGURES

The present invention will be described with reference to the figures, which are not intended to limit the present invention.

Fig. 1 shows the structure of a pressure sensor according to one embodiment of the present invention, wherein Fig. 1.1 shows the cross-sectional view of the sensor and Fig. 1.2 shows the stereogram of the layers of the sensor.

Fig.2 shows the structure of a pressure sensor according to another embodiment of the present invention.

Fig. 3 shows a schematic diagram of the electrode set, wherein Fig. 3.1 shows the electrode set design at one point of the pressure sensor according to an embodiment of the present invention; Fig. 3.2 is the enlarged diagram of the set showing distance between the edges of two neighboring electrodes in an electrode set; Fig. 3.3 is a schematic diagram of transparent electrode consisting of transparent PEDOT:PSS electrode and Ag electrode line.

Fig. 4 is a schematic diagram of neighboring electrode sets.

Fig. 5 is a schematic diagram of the distance between two neighboring electrode sets.

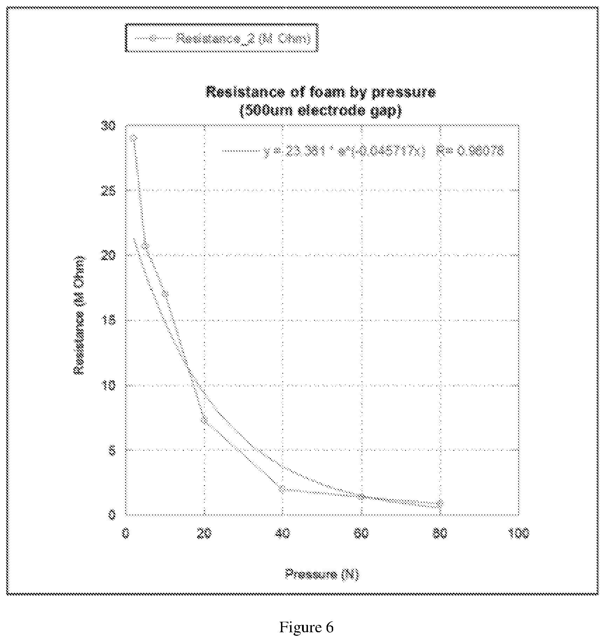

Fig. 6 shows the resistance of the piezoresistive pressure sensor according to example 1 as a function of pressure applied onto the working electrode set.

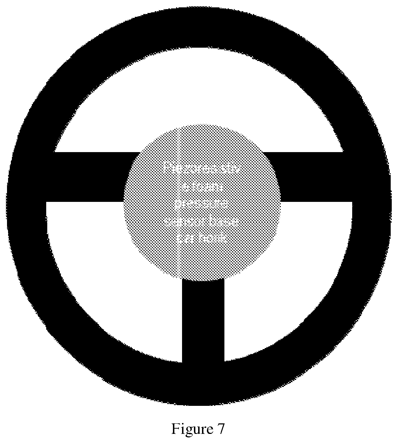

Fig. 7 shows the piezoresistive pressure sensor integrated into car horn in car steering wheel to control the volume of horn with pressure

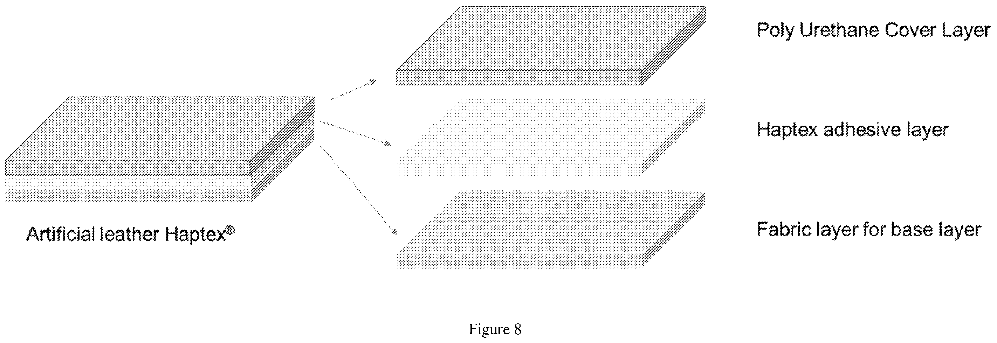

Fig. 8 shows the full layer structure of an artificial leather as cover layer according to one embodiment of the present invention.

Fig. 9 shows the resistance of a piezoresistive pressure sensor as a function of number of press applied onto different foam type pressure sensors in the reliability test.

Fig. 10 shows the tester for reliability test.

Fig. 11 shows the resistance of a piezoresistive pressure sensor as a function of pressure applied onto different foam type pressure sensors in the grey level test.

Fig. 12 shows a schematic diagram of the grey level test.

Fig. 13 shows the resistance and translucency change of a piezoresistive pressure sensor with PE foam layer.

Fig. 14 shows the resistance and translucency change of a piezoresistive pressure sensor with PU foam layer.

Fig. 15 shows the resistance and translucency change of a piezoresistive pressure sensor with Melamine foam layer.

## MODE OF CARRYING OUT THE INVENTION

Unless defined otherwise, all technical and scientific terms used herein have the meaning commonly understood by a person skilled in the art to which the invention belongs.

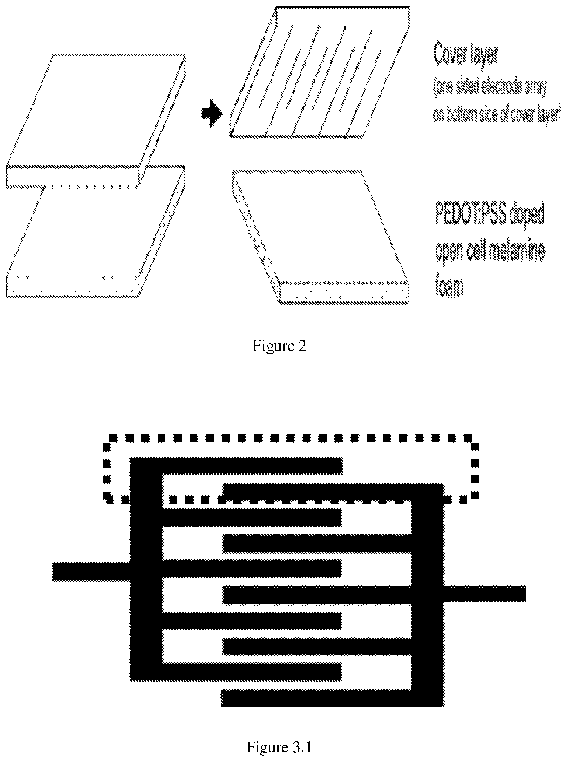

In the present invention, the term of "electrode set" means the single structural unit for forming the electrode array, as shown in figure 3.1.

In the present invention, the term of "electrode pixel" means the functional unit for implementing a function of the piezoresistive pressure sensor and consists of an electrode set or electrode sets and the continuous piezoresistive foam layer disposed thereon. The whole electrode array layer can correspond to an electrode pixel or consists of multiple electrode pixels for implementing multiple corresponding functions.

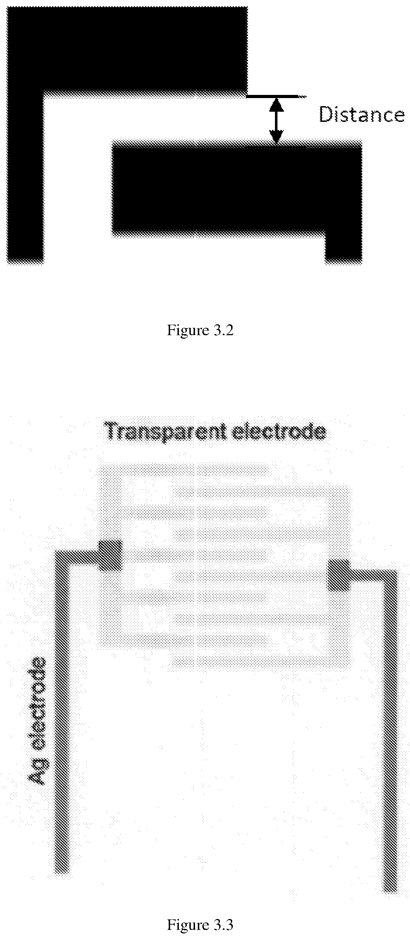

In the present invention, as shown in figure 3.2, the term of "distance between the edge of two neighboring electrodes in an electrode set" means the vertical separation distance between the two closest electrodes.

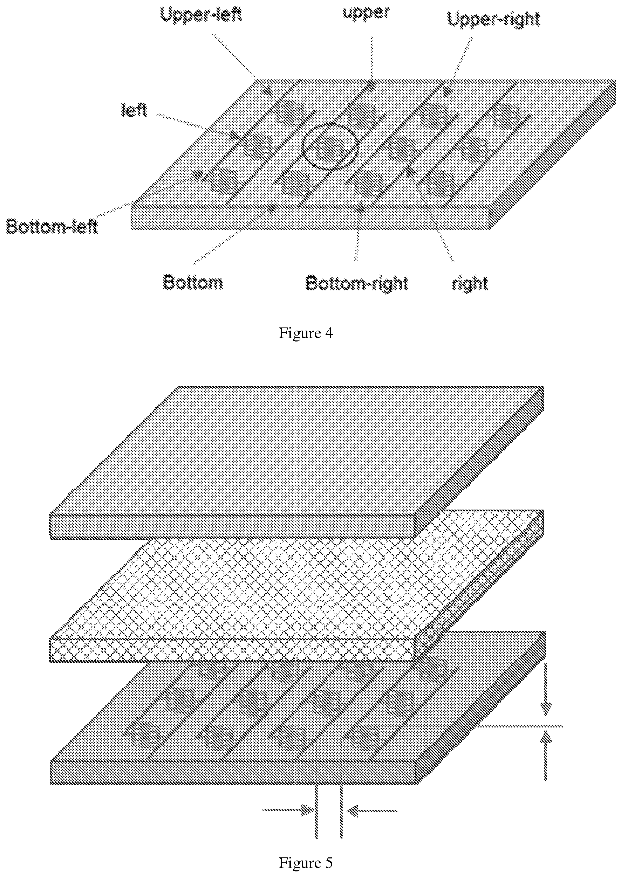

In the present invention, as shown in figure 4, the term of "a neighboring electrode set" means any of surrounding electrode sets relative to the central electrode set, i.e., an electrode set located at upper, left, right, bottom, upper-right corner, upper-left corner, bottom-right corner, or bottom-left corner of the central electrode set.

In the present invention, as shown in figure 5, the term of "the distance between two neighboring electrode sets" means the vertical separation distance between the two closest electrode sets.

In one aspect, the invention provides a piezoresistive pressure sensor, comprising:

a continuous piezoresistive foam layer;
an electrode array layer, on one side of which the continuous piezoresistive foam layer is disposed; and
an artificial leather layer as cover layer, which is disposed on the continuous piezoresistive foam layer;
wherein the continuous piezoresistive foam layer is made by doping the foam with conductive materials.

Many conductive materials may be used for the present invention. For example, the conductive material may be selected from the group consisting of Au, Ag, Cu, Ni, carbon nano tube (CNT), carbon black, graphene, a ceramic material, and an organic conductive material. In the present invention, the conductive material is preferably chosen from organic conductive materials. Many organic conductive materials may be used, such as polyaniline or its derivative, polypyrrole or its derivative, polythiophene or its derivative, polyphenylene vinylene or its derivative, polyphenylene or its derivative, polyacene or its derivative or a copolymer of those materials. The process of doping the foam is the deposition of the conductive material to the outer surface and inner surface of the foam which yields the piezoresistive foam. Many processes may be used for such deposition of the conductive material to the foam. Preferable are all liquid-applied processes including printing and coating processes (e.g. dip coating, spray coating, etc.) as those processes are readily available, cost-efficient and applicable to small to large areas.

In a preferred embodiment, the conductive materials can be applied in liquid form to the foam. In a preferred embodiment, the conductive material is PEDOT:PSS (poly(3,4-ethylenedioxythiophene):poly(styrenesulfonate)). PEDOT:PSS doped foam is commercially available, or can be produced by methods known in the art. For example, doping of commercially available foams with PEDOT:PSS can be conducted via standard coating methods (e.g. dip coating, spray coating, etc.). Many of the commercially available PEDOT:PSS products may be used for the present invention, such as those from Heraeus, Merck or Sigma-Aldirch. Those PEDOT:PSS materials may be available with different concentration or grades, such as 1.0 wt% (in $H_2O$), 1.3 wt% (in $H_2O$), 2.8 wt% (in $H_2O$), 3.5 wt% (in $H_2O$), 5.0 wt% (in $H_2O$), etc.

In one embodiment, the conductive materials may have a conductivity of no less than 1 mS/cm, preferably no less than 1.5 mS/cm, and more preferably no less than 2 mS/cm.

The foam in the present invention refers to a material having a cellular structure, where the cells can be open (reticulated) or closed. Preferably, they are open cells. A wide variety of materials can be used, including various thermoplastics or thermosetting resins. Examples of materials that can be used include melamine materials, polyacetals, polyacrylics, styrene-acrylonitrile (SAN), polyolefins, acrylonitrile-butadiene-styrene (ABS), polycarbonates, polystyrenes, polyesters (PE) such as polyethylene terephthalates and polybutylene terephthalates, polyamides such as Nylon 6, Nylon 6,6, Nylon 6,10, Nylon 6,12, Nylon 11 or Nylon 12, polyamideimides, polyarylates, polyurethanes, ethylene propylene rubbers (EPR) , epoxies, phenolics, silicones, and the like, or a combination comprising at least one of the foregoing.

The properties of the foam (e.g., density, modulus, compression load deflection, tensile strength, tear strength, open cell content and so forth) can be adjusted by varying the components of the reactive compositions as is known in the art. The foams used for the present invention are soft and can have a density, according to EN ISO 845, of below 20 $kg/m^3$, preferably below 15 $kg/m^3$, and more preferably below 11 $kg/m^3$, or above 70 $kg/m^3$ and below 500$kg/m^3$, preferably above 80 $kg/m^3$ and below 400$kg/m^3$, more preferably above100 $kg/m^3$ and below 300$kg/m^3$, according to the types of the used foam; a compressive strength, according to EN ISO 3386-1, of more than 5 kPa, preferably more than 7 kPa, and more preferably more than 9 kPa; a tensile strength, according to ISO 1798, of more than 80 kPa, preferably more than 100 kPa, and more preferably more than 120 kPa; a hardness, according to ISO 2439 B, below 300 N for 40% compression ratio, preferably below 250 N for 40% compression ratio, and more preferably below 200 N for 40% compression ratio; and an elongation at break, according to ISO 1798, of more than 12%, preferably more than 15% and more preferably more than 18%; and an open cell content, according to EN ISO 4590, of above 80 v%, preferably above 90 v%, more preferably above 95 v%, for example 100 v%.

In the present invention, the thickness of the open cell foam of the piezoresistive foam layer can be varied within a relatively large range, such as 0.1 to 200mm, according to the actual requirements. The conductive material can be deposited to the outer surface and inner surface of the open cell foam. The conductive material doped area in the open cell foam can be controlled from 0.5 to 200 mm of the thickness independent to the total thickness of the foam.

In a preferred embodiment of the present invention, the open cell foam is based on melamine/formaldehyde resin, such as the commercially available foam from BASF (e.g. Basotect® series). In a preferred embodiment, Basotect® G+melamine foam is used. The foam may be tailored to have a thickness of 0.1 to 100 mm, preferably of 0.2 to 75 mm, more preferably of 0.5 to 50 mm and most preferably of 0.8 to 25 mm. The melamine foam may have a density of below 20 kg/m$^3$, preferably below 15 kg/m$^3$, such as 8-12 kg/m$^3$ ; has an open cell content of above 95 v%, preferably above 98 v%, for example 100 v%. The melamine foam can be cut into any size and shape easily.

In a preferred embodiment of the present invention, the open cell foam is based on polyesters (PE), preferably polyethylene terephthalates and polybutylene terephthalates. The foam may be tailored to have a thickness of 0.1 to 200 mm, preferably of 0.2 to 100 mm, more preferably of 0.5 to 50 mm and most preferably of 0.8 to 25 mm. The polyesters (PE) is flexible and may have a density of above 70 kg/m$^3$ and below 500 kg/m$^3$, preferably above 80 kg/m$^3$ and below 400kg/m$^3$, more preferably above100 kg/m$^3$ and below 280 kg/m$^3$; has an open cell content of above 80v%, preferably above 90 v%, more preferably above 95 v% , for example 98-100 v%. The PE foam can be cut into any size and shape easily according to actual requirements.

In a preferred embodiment of the present invention, the open cell foam is based on polyurethanes (PU). The foam may be tailored to have a thickness of 0.1 to 200 mm, preferably of 0.2 to 100 mm, more preferably of 0.5 to 50 mm and most preferably of 0.8 to 25 mm. The polyurethanes (PU) is flexible and may have a density of above 70 kg/m$^3$ and below 500 kg/m$^3$ , preferably above 80 kg/m$^3$ and below 400 kg/m$^3$, more preferably above100 kg/m$^3$ and below 280 kg/m$^3$; has an open cell content of above 80 v%, preferably above 90 v%, more preferably above 95 v% , for example 98-100 v%. The PU foam can be cut into any size and shape easily according to actual requirements.

In the present invention, the used open cell foams have good resilience ratio of above 90%, preferably above 95%. Here, the resilience ratio is defined as follows:

resilience ratio % = the thickness of the foam recovered after being pressed/ the initial thickness of the foam x 100% wherein the thickness of the foam recovered after being pressed is determined as follows:

(1) applying a pressure of 2 kgf on a foam having a size of 20mm x 20 mm x 5 mm (length x width x thickness) for 3 seconds, and then removing the pressure and recording the thickness of the foam immediately;
(2) repeating the above step three times and taking the average thereof as the thickness of the foam recovered after being pressed.

In the present invention, the artificial leather can be any commercial materials suitable for manufacturing piezoresistive pressure sensor. In a preferred embodiment of the present invention, the artificial leather is based on polyurethanes, such as artificial leather Haptex®.

For pressure sensor applications, it is important to control the current leakage of piezoresistive layer on the electrode array so that it is no higher than the data scanning noise. To control the current leakage, it is preferred that the surface resistance of the doped foam, without any external pressure, is adjusted to more than 4 G Ohm/mm, preferably more than 5 G Ohm/mm. In this way, electrical short-circuit between neighboring electrode sets can substantially be prevented and the accuracy of the pressure sensor can be improved. The surface resistance can be adjusted by the doping amount or conductivity of the conductive material. For example, when PEDOT:PSS is used as the conductive material, the doping amount of PEDOT:PSS inside the foam may be 1e^-7 g/mm$^3$to 1e^-5 g/mm$^3$, preferably 3e^-6 g/mm$^3$ to 8e^-6 g/mm$^3$, and more preferably 5e^-6 g/mm$^3$ to 7e^-6 g/mm$^3$, based on the volume of the PEDOT:PSS doped foam.

In a more preferred embodiment, the doping amount of the conductive material is adjusted so that the pressure sensor meets the following formula:

$$\text{Resistance (M Ohm)} = K \times e^{\wedge}(b \times \text{Pressure (N)})$$

wherein the Resistance means the average resistance between any of the edge of two neighboring electrodes with a distance of 0.5 mm in an electrode set, K is a number in the range of 10 to 50, b is a number in the range of -0.02 to -0.05, and the Pressure means the pressure applied onto a circular area on the sensor with a diameter of 18 mm.

The distance between any of the edge of two neighboring electrodes in an electrode set may be adjusted to meet the requirement of different application. In the present invention, an electrode set refers to a couple of electrodes that are connected together, as shown in Fig. 3.1. According to the present invention, the distance must be in the range of 0.1 to 8 mm, preferably in the range of 0.2 to 6 mm, and more preferably in the range of 0.5 to 5 mm. In addition, the number of electrode sets can be selected as needed. For pressure sensor applications, it is desired to use more electrode sets to improve the sensitivity of the sensor. For example, in the present invention, it is preferable to have at least 3 pairs of electrodes in each electrode set, preferably at least 4 pairs of electrodes in each electrode set, and more preferably at least 5 pairs of electrodes in each electrode set. As shown in Fig. 3.1, there are 5 pairs of electrodes in the electrode set. Moreover, it is beneficial to set the distance between two electrode sets in such a way that it is at least 2 times, preferably at least 3 times and more preferably at least 4 times of the distance between any of the edge of two neighboring electrodes in an electrode set. Otherwise, the sensor may show unacceptable leakage current (i.e., the current may flow between two different electrode sets). Pressure sensor meeting this requirement shows high sensitivity and low leakage current. Meanwhile, when the distance between two electrode sets is too large, the sensitivity of the senor will be decreased, for there will not be enough electrodes spread over the sensor. Therefore, it is advantagous to set the distance between two electrode sets in such a way that it is no more than 10 times, preferably no more than 8 times and more preferably no more than 6 times of the distance between any of the edge of two neighboring electrodes in an electrode set.

Current leakage can be determined by measuring the resistance of sensor under the condition of without any external pressure onto the sensor. Resistance can be determined by using commercially available source measure units, such as Keithley 2636B SYSTEM sourcemeter. In the present invention, the measurement is performed with an applied voltage of 5 V and Cu foil is used as the electrode material. Distance between the edges of two neighboring electrodes in an electrode set can be determined by any suitable instruments, such as a micrometer or digital caliper.

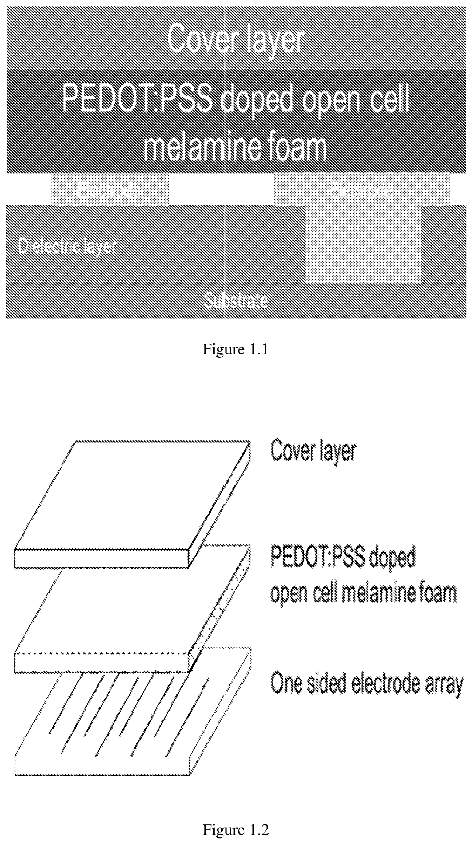

The electrode array layer may be placed either on the bottom of piezoresistive foam layer or on the top of piezoresistive foam layer. Moreover, the electrode array layer may be separately formed and then laminated with the continuous piezoresistive foam layer, or may be integrated to the cover layer, or even may be integrally formed together with the cover layer. The integration of the electrode array layer may be affected by printing, such as screen-printing, gravure printing or coating. By way of example, Fig 1.2 shows the embodiment where an electrode array layer having 3-layered structure (for example, electrode array/dielectric layer (insulator)/electrode array) is formed separately and then assembled, while Fig. 2 shows the embodiment where the electrode array layer is directly printed/coated to the one side of a cover layer. Regarding the electrode array layer, a cover layer can be optionally integrated to, its side opposite to piezoresistive foam layer. The cover layer is any suitable material in the art, as long as it serves the function of protecting the electrode array layer lying which it covers.

The material of the electrode array is known in the art, such as PEDOT:PSS, Ag, Cu, Cr, Al, Ni or the like, or any combination thereof. By way of example, PEDOT:PSS, Ag and Cu are preferably used to prepare the electrode array layer of the pressure sensor according to the present invention. In a preferred embodiment, the electrode array layer is available from screen-printing with commercial Ag or Cu inks. In another preferred embodiment, in the electrode array layer, each electrode in each electrode set is transparent electrode, such as transparent PEDOT:PSS electrode with Ag electrode line or with Al, Au, Cu and the like.

The manufacturing process of the electrode array is well known to the skilled person in the art. The electrode array layer may have a 1-layered structure or 3-layered structure, such as electrode array/insulator/electrode array. Each electrode array layer may have certain number of electrode sets. As an example, Figures 3 and 4 show the top view of the schematic diagram of the structure of an electrode set. In this example, an electrode set has five pairs of electrodes. However, there can be more or less pairs of electrodes in each electrode set.

In the present invention, a cover layer serves the function of protecting the layer lying under it, and may be formed from any flexible material known in the art as needed.

In a preferred embodiment of the present invention, Haptex®(manufactured by BASF), which has soft touch, is preferably used to produce the artificial leather layer as cover layer of the pressure sensor according to the present invention, and provides the sensor with improved user experience, including soft and smooth surface feeling combined with sensing functionality.

In a preferred embodiment of the present invention, the artificial leather layer is a flexible composite which can be double-layer structure, i.e. having a basal layer and a surface layer. Preferably, the flexible composite can be three-decker, i.e. having a basal layer, a surface layer and at least one surface covering layer being coated on the surface layer. Optionally, the surface-treated layer can also be coated on the surface covering layer, to obtain better sense of touch. Regarding the flexible composite according to the present invention, the thickness of basal layer can be selected as 0.2-1.5 mm, preferably 0.3-1.2 mm, more preferably 0.5-1.1 mm, further preferably 0.7-0.9 mm; the thickness of surface layer can be selected as 100-800 μm, preferably 130-700 μm, more preferably 200-600 μm, further preferably 300-500 μm; and the thickness of the surface covering layer is 15-200 μm, preferably 20-160 μm, more preferably 50-130 μm, further

preferably 80-110 $\mu$m. It will be appreciated by those skilled in the art that above-mentioned thickness value is only preferred and can be adjusted according to the required translucency.

For the flexible composite having double-layer structure, the material for forming basal layer can be selected from knitted fabric or non-woven fabric; the material for forming surface layer can be selected from polyvinylchloride, polyurethane PU, thermoplastic polyurethane TPU and thermoplastic polyolefin TPO.

For the flexible composite having three-layer structure, the material for forming basal layer can be selected from knitted fabric or non-woven fabric; the material for forming surface layer can be selected from polyvinylchloride, polyurethane PU, thermoplastic polyurethane TPU or thermoplastic polyolefin TPO; the material of surface covering layer can be selected from polyurethane PU, TPU, acrylic compounds, natural or modified cellulose family. In one embodiment, basal layer can be made of non-woven fabric, and surface layer can be made of polyurethane PU, and surface covering layer are formed by being coated to polyurethane PU dispersion of the surface layer backwards to the side of basal layer. The polyurethane PU of surface layer can be foamed or not foamed. In another embodiment, the basal layer can be formed by knitted fabric, and the surface layer can be formed by thermoplastic polyurethane, wherein thermoplastic polyurethane can be for example integrated on the basal layer by a rolling process, and the surface covering layer is optionally present. In a preferred embodiment of the present invention, the artificial leather layer is commercially available under the product name Haptex®, manufactured by BASF.

In a preferred embodiment of the present invention, the artificial leather layer and the continuous piezoresistive foam layer, independently from each other, have a translucency of 1% or lower.

In a preferred embodiment of the present invention, the artificial leather layer and the continuous piezoresistive foam layer, independently from each other, have a translucency of higher than 3%; in the electrode array layer, each electrode in each electrode set is transparent electrode, such as transparent PEDOT:PSS electrode with Ag electrode line. By this way, a transparent piezoresistive pressure sensor can be achieved that is suitable for use as a sensor with backlight integration with good translucency.

In a preferred embodiment of the present invention, to control the current leakage, the surface resistance of the continuous piezoresistive foam layer, without any external pressure, is adjusted to more than 4G Ohm/mm, preferably more than 5G Ohm/mm.

In a more preferred embodiment, to prevent electrical short cuts with neighboring electrode sets, the surface resistance of the continuous piezoresistive foam layer meets the following formula:

Resistance (M Ohm) = 8.4444 - (0.73333 x distance (mm)) + (0.28889 x distance$(mm)^2$)

wherein the Resistance is measured under 0.036 kgf pressure and the distance means a distance between two neighboring electrode sets.

In a preferred embodiment of the present invention, in the electrode array layer, each electrode in each electrode set is transparent electrode, such as transparent PEDOT:PSS electrode with Ag electrode line, as shown in figure 3.3.

In another aspect, the invention provides a control system, comprising the inventive piezoresistive pressure sensor.

In a preferred embodiment of the present invention, the control system is used on dashboard, center console or middle console, or car horn.

In one aspect, the invention provides car horn control system in car steering wheel for analog control of car horn volume, wherein the car horn control system comprising a piezoresistive pressure sensor as described above.

The piezoresistive pressure sensor can be integrated into the car horn in car steering wheel to control the volume of horn with pressure. The integration method is any conventional method known to those skilled in the art without limitation.

In a preferred embodiment of the present invention, in the car horn control system, the piezoresistive pressure sensor comprises

a continuous piezoresistive foam layer;
an electrode array layer, on one side of which the continuous piezoresistive foam layer is disposed; and
an artificial leather layer as the cover layer, which is disposed on the continuous piezoresistive foam layer;
wherein the continuous piezoresistive foam layer is made by doping the foam with conductive materials.

The electrode array layer can be designed as 1-layered structure for one point readout with one control function, i.e., forming one electrode pixel, or as 3-layered structure for 2D mapping with additional control function (for example, music volume control, aircon control, window control and so on) with pressure readout.

In a preferred embodiment of the present invention, in the car horn control system, the artificial leather layer is based on polyurethanes having sufficient flexibility, reliability and feeling, for example Haptex® from BASF.

In a preferred embodiment of the present invention, the thickness of the open cell foam of the piezoresistive foam layer can be varied within a relatively large range, such as from 0.5 to 200 mm, according to the actual requirements. The conductive material can be deposited to the surface and inner surface of the open cell foam. The conductive material doped area in the open cell foam can be controlled from 0.5 to 200 mm of the thickness independent to the total thickness of the foam, for example 5 mm of conductive material doped foam with full thickness of 50 mm foam.

In the present invention, the resistance (a representative parameter for the sensitivity property) of the piezoresistive foam layer is controllable and depends on the user needs and the readout system. The sensitivity (equivalent to the resistance change) of the piezoresistive foam is in a range of about 10 G ohm to 10 K ohm (higher than $10^5$ order difference), which makes the piezoresistive pressure sensor have more grey level to sense the pressure more precisely. In a preferred embodiment of the present invention, the resistance of the piezoresistive foam layer is varying from about 10 G ohm to $10 \pm 5$ K ohm under 2kgf pressure with the piezoresistive foam size of 20 x 20 mm (length x width) on I mm gap of two Cu electrode (Cu tape).

In a preferred embodiment of the present invention, the continuous piezoresistive foam layer has a thickness of 1-15mm, preferably 3-10 mm, a width of at least 50mm, preferably at least 60mm, and a ratio of length to width of (1-15):1, preferably (1-10):1, more preferably (1-5):1, especially (1-3):1. However, the continuous piezoresistive foam layer can have small size according to practical requirements, such as smaller sensor for car interior application, for example, for smart horn, middle console and dashboard.

Preferably, the piezoresistive pressure sensor has a size of at least 105 mm x 70 mm (length x width), preferably at least 150mm x 90mm, and more preferably at least 250 mm x 120 mm. Piezoresistive pressure sensor of larger size can be manufactured more easily. In one embodiment, the continuous foam layer may comprise more than one piece of foam. For example, the continuous foam may comprise at least two pieces of foam, or at least four pieces of foam, or at least 9 pieces of foam.

The piezoresistive pressure sensor according to the present invention may have a total thickness in the range of 0.5 mm to 220 mm, preferably in the range of 0.5 mm to 120 mm, preferably in the range of 1 mm to 100 mm, more preferably in the range of 1.5 mm to 60 mm, and most preferably in the range of 2 mm to 30 mm. It has good flexibility and reliability and can be used as sensors for car seat pressure mapping for user feedback for orthotherapy, for piano keyboard with better feeling with physical changes of sensor thickness due to high grey level, for pillow for sleep monitoring, or for shoes, sportswear, mouse pad, furniture, sensors for car interior and the like.

The present invention also provides a process for producing piezoresistive pressure sensor, comprising:

    a) preparing an electrode array layer, and optionally integrating the electrode array layer to a cover layer;
    b) disposing a continuous piezoresistive foam layer on one side of an electrode array layer; and
    c) disposing an artificial leather layer on the continuous piezoresistive foam layer,

wherein the continuous piezoresistive foam layer is made from conductive materials doped foam.

In one aspect, the invention provides the use of piezoresistive pressure sensor in a control system of dashboard, a center console, a middle console, or a car horn.

In the present invention, a combination layer of an artificial leather layer and a continuous piezoresistive foam layer is used for producing piezoresistive pressure sensor. The combination layer means the physically connected an artificial leather layer and a continuous piezoresistive foam layer in the piezoresistive pressure sensor.

The above definitions and description concerning entire structure of the piezoelectric pressure sensor, the material of the electrode array layer, the continuous piezoresistive foam layer and the cover layer also apply to the process.

The preparation of the electrode array layer may be conducted by any suitable method known in the art, for example, by printing or coating an ink containing metal particles, or cutting a metal foil.

The electrode array layer, the continuous piezoresistive foam layer and the cover layer can be laminated together by conventional method, for example, by using adhesive, welding, or fusing under heating. Alternatively, the electrode array layer, the continuous piezoresistive foam layer and the cover layer can be integrally formed together by conventional method, for example, by lamination.

The present invention will now be described with reference to Examples and Comparative Examples, which are not intended to limit the present invention.

## Example

## Example 1

Sensitivity test of the pressure sensors with different distances between the neighboring electrode sets:

Starting materials:

Open cell foam: melamine/formaldehyde resin foam (ML foam), Basotect® G+, from BASF SE; PU foam, which is flexible and has a density of 200 kg/m$^3$ and an open cell content of 95 v%; polyesters (PE) foam, which is flexible and has a density of 180 kg/m$^3$ and an open cell content of 100 v%. Those used open cell foams have resilience ratio of about 96%;

PEDOT:PSS: commercial product from Sigma-Aldrich, having a conductivity around 1 S/cm and a solid contents of 1.3 wt% (aqueous solution);

Cover layer: Haptex®, from BASF SE;

Ag paste.

Test Methods:

Resistance was determined by instrument Keithley 2636B SYSTEM SourceMeter with 5V voltage or Keithley2612B SYSTEM SourceMeter with 5V voltage. For each resistance measurement, tests were performed three times and an average resistance was recorded as the final result.

Distance between the edges of two neighboring electrodes in an electrodes set was determined by measuring the gap of two Cu tape electrodes.

Preparation of the pressure sensor:

Piezoresistive foam layer was fabricated by applying 10 g of PEDOT:PSS solution (1.3wt% of PEDOT:PSS in H$_2$O, from Sigma-Aldrich) via dip coating to a sheet of Basotect® G+ of 105 mm x 70 mm x 3 mm. The Piezoresistive foam layer contained 5.9 e^-6 g/mm$^3$ of PEDOT:PSS.

The electrode array layer was formed by coating the Ag paste on the cover layer. Then, the piezoresistive foam layer and the integrated electrode array layer and the cover layer were laminated by 3M™ Scotch-Weld Epoxy Adhesive. In the following examples, the obtained pressure sensor had 160 electrode sets in a 16 x 10 arrangement (i.e., 16 sets in each row in 105 mm length direction and 10 sets in each row in 70 mm width direction) and the distance between the two neighboring sets was 0.5 mm.

The resistance of the pressure sensor was measured as a function of the pressure applied by TECLOCK GS-709N type A (ASTM D 2240A, JIS K 868 A, ISO R868 A). For each measurement, certain force was applied onto an electrode set (working set, WS) and corresponding resistance was recorded. Meanwhile, the resistance on the neighboring electrode set (neighboring set, NS) was also recorded.

The distance between neighboring electrode sets has an influence on the resistance of the sensor, which in turn represents the degree of the sensitivity of the sensor. In the following examples, NS3, NS1.5 and NS0.5 mean that the distance from the working electrode set to the neighboring electrode set is 3 mm, 1.5 mm and 0.5 mm, respectively. The distance between any two neighboring electrodes in each electrode set was fixed at 0.5 mm.

The ratio of the resistance of the electrode set to the resistance of the working electrode set (the "resistance ratio") was also calculated for charactering the sensitivity of the sensor.

The result is shown in Table 1.

| Pressur e (N) | Resistivity (M ohm) | | | | Resistivity ratio | | |
|---|---|---|---|---|---|---|---|
| | NS3 | NS1.5 | NS0.5 | WS | NS3/ WS | NS1.5/ WS | NS0.5/ WS |
| 0 | 2000 | 2000 | 2000 | 200 0 | N.A. | N.A. | N.A. |
| 2 | 1433.3 | 533.3 | 46.7 | 29.0 | 49.4 | 18.4 | 1.6 |
| 5 | 1400.0 | 496.7 | 26.7 | 20.7 | 67.7 | 24.0 | 1.3 |
| 10 | 1216.7 | 510.0 | 29.7 | 17 | 71.6 | 30.0 | 1.7 |
| 20 | 830.0 | 506.7 | 31.7 | 7.3 | 113.2 | 69.1 | 4.3 |
| 40 | 700.0 | 123.3 | 24.0 | 2.0 | 350.0 | 61.7 | 12.0 |

(continued)

| Pressur e (N) | Resistivity (M ohm) | | | | Resistivity ratio | | |
|---|---|---|---|---|---|---|---|
| | NS3 | NS1.5 | NS0.5 | WS | NS3/ WS | NS1.5/ WS | NS0.5/ WS |
| 60 | 530.0 | 21.7 | 24.0 | 1.4 | 380.4 | 15.6 | 17.2 |
| 80 | 766.7 | 10.7 | 19.3 | 0.9 | 902.0 | 12.5 | 22.7 |

From the result, it can be seen that when there is no pressure, the resistance of the sensor is extremely high, which inhibits current leakage between electrode sets, and thus false detection can be reduced. It is also clear that when the distance between two neighboring electrode sets is too short as shown by NS0.5, the resistance ratio between the working electrode set and neighboring electrode set is too low, which will decrease the sensitivity of the sensor. Clearly, the distance between two electrode sets cannot be too small, otherwise the sensitivity of the sensor would be impaired. Compared with NS0.5, the electrode sets of NS1.5 and NS3 lead to significantly better sensitivity under small pressure.

In addition, it can be seen that the doping amount of PEDOT:PSS as used above is also beneficial to the achievement of good sensitivity, implying that 2D-pressure mapping can be well performed. Thus, the inventive pressure sensor can well function without applying sophisticated algorithm.

**Example 2**

Reliability test of the pressure sensors having different type of piezoresistive foam layer:

The pressure sensor was prepared by the same method as shown in Example 1, except that the foam was made by the materials shown in Tables 2 and 3.

The reliability measurement of the pressure sensor proceeded under the following conditions:

Pressure applied being 2kgf;
Cu tape electrode with 1 mm gap;
PEDOT:PSS used as conductive material, and Thinner = DIW : IPA (1: 2);
PEDOT: Thinner ratio =1:15 dilution
30 x 30 mm foam size for each pressure sensor;
3 mm thickness for melamine foam, and 5 mm or 10 mm thickness for PU foam.

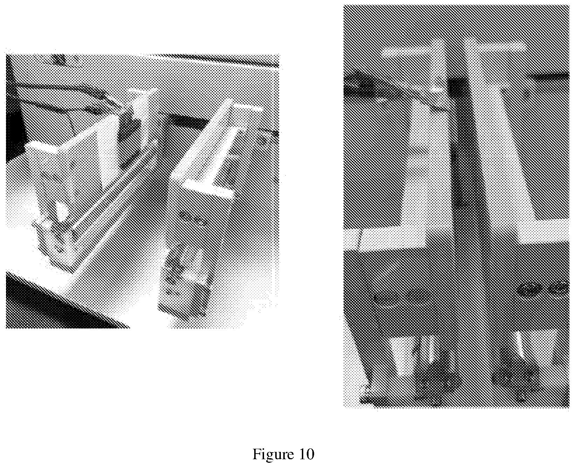

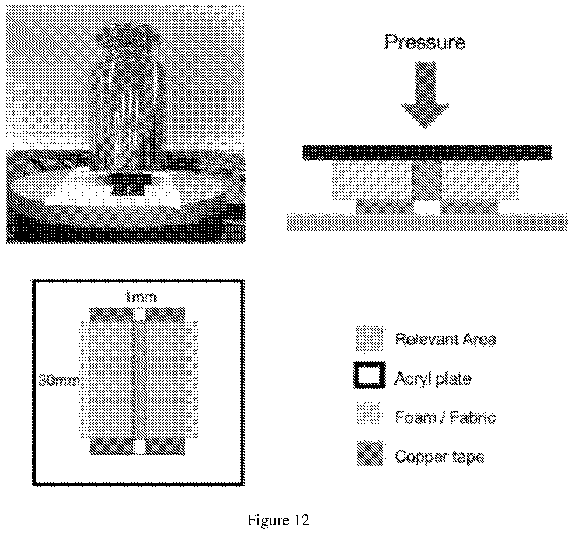

As shown in figure 10, radius bending tester was used to apply pressure on piezoresistive foam by controlling a distance (i.e., radius bending tester gap in table 2) between the clamp plates of the tester. Foam samples having a size of 30 mm x 30 mm (length x width) and a thickness of 3, 5 or 10 mm were used to measure electrical reliability of piezoresistive foam pressure sensor. In addition, 0.6 mm gap, 1 mm gap or 3 mm gap (i.e., the compressed thickness of the foam) were applied respect to the foam thickness of 3, 5 or 10 mm respectively. The equipment of Keithley2612B was used to measure resistance with 2kgf pressure, 5V voltage and 1 mm gap of Cu electrode therein. Measurement set-up was the same as that in the grey level measurement as shown in figure 12.

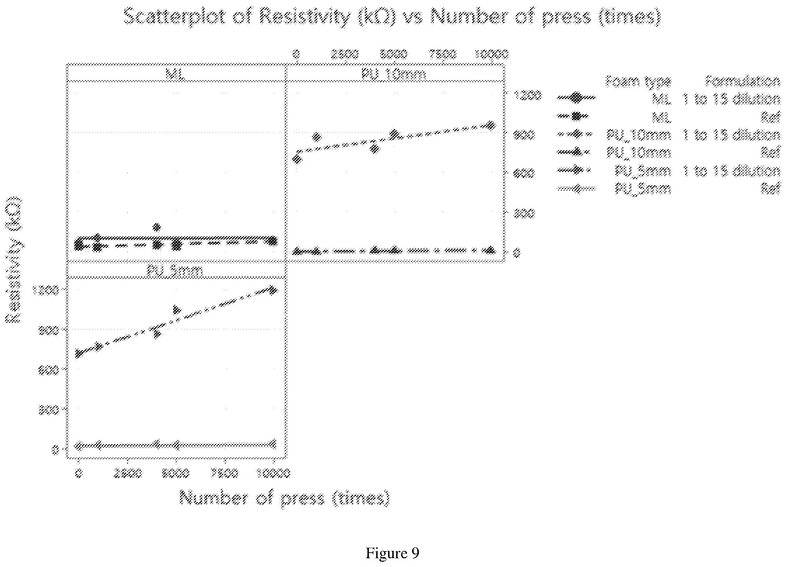

The result is shown in Tables 2-3 and figure 9.

Table 2

| Foam type | Original thickness (mm) | Original volume (mm$^3$) | Radius bending tester gap (mm) | Thickness change (mm) | Reduced Thickness (mm) | Reduced volume (mm$^3$) | Reduced volume/ Original volume (%) |
|---|---|---|---|---|---|---|---|
| ML_3 mm | 3 | 2700 | 0.6 | -0.74 | 2.25 | 2034 | 75.3 |
| PU_5 mm | 5 | 4500 | 1 | -1.14 | 3.86 | 3474 | 77.2 |
| PU_10 mm | 10 | 9000 | 3 | -3.14 | 6.86 | 6174 | 68.6 |

Table 3

| Foam type | Number of press (times) | Resistivity (M ohm) |
|---|---|---|
| ML_3 mm (Ref) | 0 | 0.047 |
| | 1000 | 0.041 |
| | 5000 | 0.062 |
| | 10000 | 0.052 |
| | 20000 | 0.084 |
| ML_3 mm (1:15 dilution) | 0 | 0.076 |
| | 1000 | 0.11 |
| | 5000 | 0.19 |
| | 10000 | 0.08 |
| | 20000 | 0.095 |
| PU_5 mm (Ref) | 0 | 0.02 |
| | 1000 | 0.033 |
| | 5000 | 0.04 |
| | 10000 | 0.028 |
| | 20000 | 0.034 |
| PU_5 mm (1:15 dilution) | 0 | 0.720 |
| | 1000 | 0.77 |
| | 5000 | 0.87 |
| | 10000 | 1.05 |
| | 20000 | 1.20 |
| PU_10 mm (Ref) | 0 | 0.0049 |
| | 1000 | 0.004 |
| | 5000 | 0.008 |
| | 10000 | 0.011 |
| | 20000 | 0.014 |
| PU_10 mm (1:15 dilution) | 0 | 0.700 |
| | 1000 | 0.870 |
| | 5000 | 0.780 |
| | 10000 | 0.900 |
| | 20000 | 0.960 |

From the results, it can be seen that compared with the initial resistances, resistance changes of inventive melamine foam and PU foam after 20000 times are small and those foams still show good sensitivity, implying that those foams have excellent reliability.

In addition, it is clear that the doping amount of PEDOT:PSS has great influence on the sensitivity of the pressure sensors. For foam samples of ML_3mm (Ref), PU_5mm (Ref) and PU_10mm (Ref), the doping amount of PEDOT:PSS are 4.8 e^-5 g/mm$^3$, 2.89 e^-5 g/mm$^3$ and 1.44 e^-5 g/mm$^3$, respectively. For inventive foam samples of ML_3mm (1:15 dilution), PU_5mm (1:15 dilution) and PU_10mm (1:15 dilution), the doping amount of PEDOT:PSS are 3.2 e^-6 g/mm$^3$, 1.9e^-6 g/mm$^3$ and 0.96 e^-6 g/mm$^3$, respectively. By adjusting the doping amount of PEDOT:PSS, the pressure sensors can achieve good sensitivity.

**Example 3**

Grey level test of the pressure sensors (another indication showing the sensitivity of the sensor) having different type of piezoresistive foam layer:

The pressure sensor was prepared by the same method as shown in Example 1, except that 3.5 wt% of PEDOT:PSS solution was used to replace 1.3 wt% of PEDOT:PSS solution and the foam was made by the materials shown in Table 4.

The grey level measurement of the pressure sensor proceeded under the following conditions:

Pressure of 0.1 kgf, 0.3 kgf, 1 kgf and 2kgf respectively, applied by balance weights;
Cu tape electrode with 1mm gap;
PEDOT:PSS used as conductive material, and Thinner = DIW : IPA (1: 2);
PEDOT: Thinner ratio =1:15 dilution
30 x 30 mm foam size for each pressure sensor;
3 mm thickness for melamine foam, and 5 mm or 10 mm thickness for PU foam.

As shown in figure 12, Keithley2612B was used to measure resistance with 0.1, 0.3, 1 and 2 kgf of pressure, respectively. The foam samples had a size of 30 mm x 30 mm (length x width) with 3 mm thickness for melamine foam, and 5 mm or 10 mm thickness for PU foam. 5V of voltage and 1 mm gap of Cu electrode in Keithley2612B were applied when measuring the resistance.

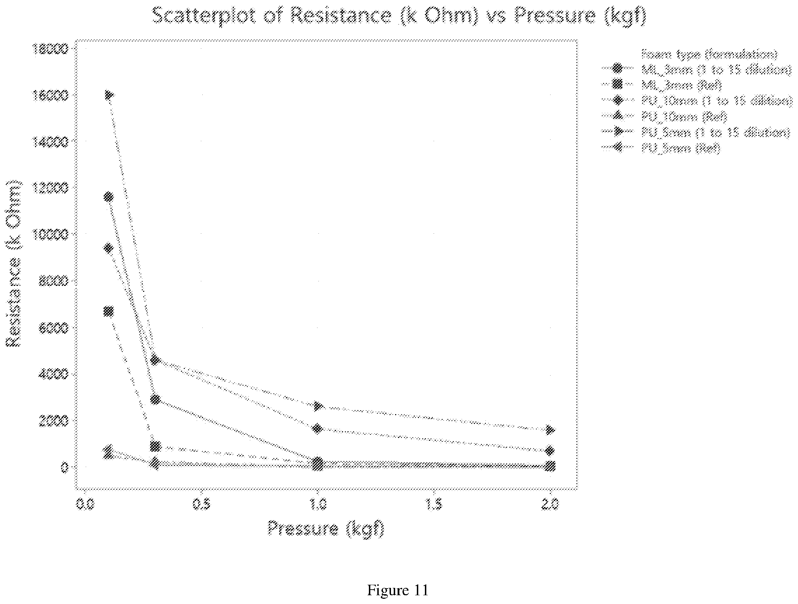

The result is shown in Table 4 and figure 11.

Table 4

| Foam type | Pressure (kgf) | Resistivity (M ohm) |
|---|---|---|
| ML_3 mm (Ref) | 2 | 0.047 |
| | 1 | 0.17 |
| | 0.3 | 0.9 |
| | 0.1 | 6.7 |
| ML_3 mm (1:15 dilution) | 2 | 0.076 |
| | 1 | 0.25 |
| | 0.3 | 2.9 |
| | 0.1 | 11.6 |
| PU_5 mm (Ref) | 2 | 0.02 |
| | 1 | 0.065 |
| | 0.3 | 0.108 |
| | 0.1 | 0.78 |
| PU_5 mm (1:15 dilution) | 2 | 1.6 |
| | 1 | 2.6 |
| | 0.3 | 4.6 |
| | 0.1 | 16 |
| PU_10 mm (Ref) | 2 | 0.049 |
| | 1 | 0.084 |
| | 0.3 | 0.23 |
| | 0.1 | 0.51 |
| PU_10 mm (1:15 dilution) | 2 | 0.7 |
| | 1 | 1.65 |
| | 0.3 | 4.6 |
| | 0.1 | 9.4 |

From the results, it can be seen that inventive melamine foam and PU foam have good grey level under 0.1 kgf pressure to 2 kgf pressure, implying that those pressure sensors are of good sensitivity and can sense the pressure more precisely.

In addition, it is clear that the doping amount of PEDOT:PSS has great influence on the sensitivity of the pressure sensors. For foam samples of ML_3mm (Ref), PU_5mm (Ref) and PU_10mm (Ref), the doping amount of PEDOT:PSS are 1.3 e^-4 g/mm$^3$, 7.78 e^-5 g/mm$^3$ and 3.89 e^-5 g/mm$^3$, respectively. For inventive foam samples of ML_3 mm (1:15 dilution), PU_5 mm (1:15 dilution) and PU_10 mm (1:15 dilution), the doping amount of PEDOT:PSS are 8.6 e^-6 g/mm$^3$, 5.3 e^-6 g/mm$^3$ and 2.6 e^-6 g/mm$^3$, respectively. By adjusting the doping amount of PEDOT:PSS, the pressure sensors can show good sensitivity.

Translucency test of the pressure sensors having different type of piezoresistive foam layer with different doping amounts:

The piezoresistive foam layer was prepared by the same method as shown in Example 1, except that the foam was made by the materials shown in Tables 5-7.

Measurement of translucency of the piezoresistive foam used Lux meter.

The translucency measurement of the pressure sensor proceeded under the following conditions:

Pressure of 2kgf applied;
Cu tape electrode with 1 mm gap;
PEDOT:PSS used as conductive material, and Thinner = DIW : IPA (1: 2);
PEDOT: Thinner ratio =1:0, 1:10, 1:15 and 1:30 dilution respectively
20 mm x 20 mm (length x width) foam size for each foam with thickness of 5 mm for PE foam and PU foam and 3mm for melamine foam;
Foam used being melamine foam, PU foam and PE foam respectively, wherein PEDOT:PSS was doped manually by hand and annealed for 30 min at 100 °C under vacuum
Ref light intensity = 25800 Lx
Target Min Resistance = 10k ohm±5k ohm

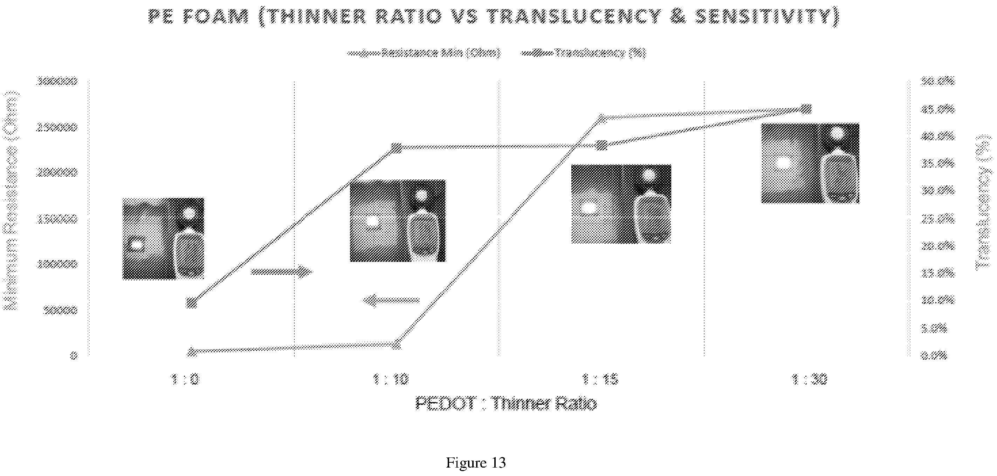

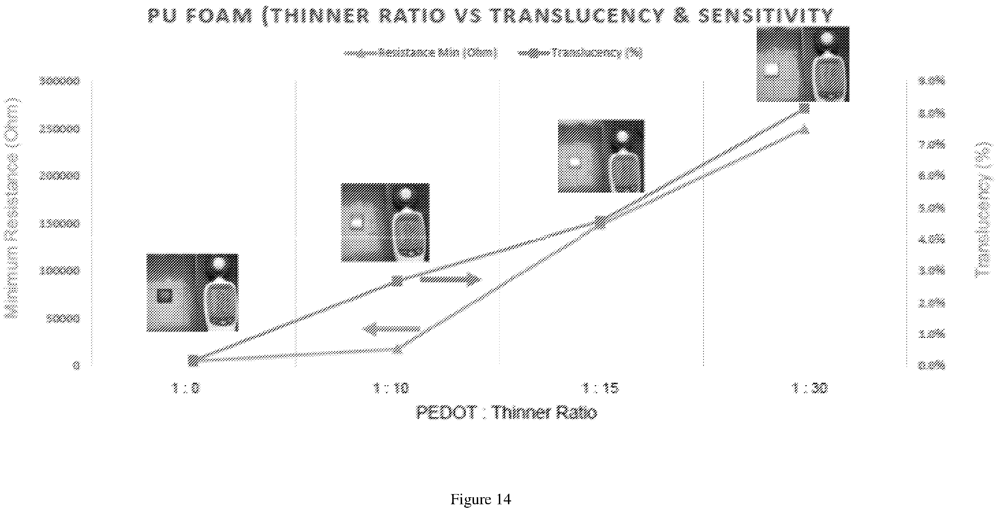

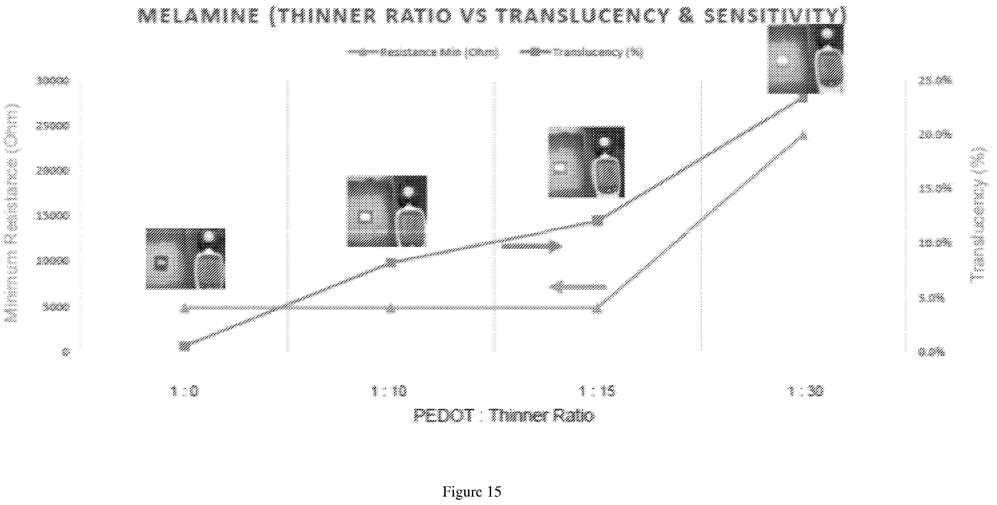

In this test, Keithley2612B was used to measure resistance with 2 kgf of pressure. 5V of voltage and 1 mm gap of Cu electrode in Keithley2612B were applied when measuring the resistance. The result is shown in Tables 5-7 and figures 13-15.

Table 5

| PEDOT:PSS ink | Thinner | foam | Translucency (Lx) | Translucency (%) | Resistance Min (M ohm) |
|---|---|---|---|---|---|
| 1 | 0 | PE1(Ref) | 2500 | 9.7% | 0.00486 |
| 1 | 10 | PE2 | 9790 | 37.9% | 0.013 |
| 1 | 15 | PE3 | 9880 | 38.3% | 0.26 |
| 1 | 30 | PE4 | 11620 | 45.0% | 0.27 |

Table 6

| PEDOT:PSS ink | Thinner | foam | Translucency (Lx) | Translucency (%) | Resistance Min (M ohm) |
|---|---|---|---|---|---|
| 1 | 0 | PU1(Ref) | 43.1 | 0.2% | 0.00486 |
| 1 | 10 | PU2 | 692 | 2.7% | 0.018 |
| 1 | 15 | PU3 | 1183 | 4.6% | 0.149 |
| 1 | 30 | PU4 | 2100 | 8.1% | 0.25 |

Table 7

| PEDOT:PSS ink | Thinner | foam | Translucency (Lx) | Translucency (%) | Resistance Min (M ohm) |
|---|---|---|---|---|---|
| 1 | 0 | ML1(Ref) | 132.3 | 0.5% | 0.00486 |
| 1 | 10 | ML2(Ref) | 2120 | 8.2% | 0.00486 |

(continued)

| PEDOT:PSS ink | Thinner | foam | Translucency (Lx) | Translucency (%) | Resistance Min (M ohm) |
|---|---|---|---|---|---|
| 1 | 15 | ML3 | 3100 | 12.0% | 0.00486 |
| 1 | 30 | ML4 | 6050 | 23.4% | 0.024 |

From the results, it is clear that the doping amount of PEDOT:PSS has great influence on the sensitivity and translucency of the pressure sensors. For foam sample of PE1(Ref) and PE2 to PE4, the doping amount of PEDOT:PSS are $6.5\,e^-5\,g/mm^3$, $6.5\,e^-6\,g/mm^3$, $4.3\,e^-6\,g/mm^3$ and $2.2\,e^-6\,g/mm^3$, respectively. For foam samples of PU1(Ref) and PU2 to PU4, the doping amount of PEDOT:PSS are $6.5\,e^-5\,g/mm^3$, $6.5\,e^-6\,g/mm^3$, $4.3\,e^-6\,g/mm^3$ and $2.2\,e^-6\,g/mm^3$, respectively. For foam samples of ML1(Ref) to ML2(Ref) and ML3 to ML4, the doping amount of PEDOT:PSS are $1.1\,e^-4\,g/mm^3$, $1.1\,e^-5g/mm^3$, $7.2\,e^-6\,g/mm^3$ and $3.6\,e^-6\,g/mm^3$, respectively. By adjusting the doping amount of PEDOT:PSS, the pressure sensors can show good sensitivity and translucency.

**Claims**

1.  A piezoresistive pressure sensor, comprising:

    a continuous piezoresistive foam layer, which is made by doping the foam with conductive materials; and
    an electrode array layer, on one side of which the continuous piezoresistive foam layer is disposed;
    **characterized in that** the piezoresistive pressure sensor further comprises
    an artificial leather layer as cover layer, which is disposed directly on the continuous piezoresistive foam layer.

2.  The piezoresistive pressure sensor according to claim 1, wherein the conductive materials are organic conductive materials with conductivity no less than 1 mS/cm.

3.  The piezoresistive pressure sensor according to any of the preceding claims, wherein the conductive material is PEDOT: PSS.

4.  The piezoresistive pressure sensor according to any of the preceding claims, wherein the surface resistance of the continuous piezoresistive foam, without any external pressure, is adjusted to more than 4G Ohm/mm.

5.  The piezoresistive pressure sensor according to claim 3, wherein the doping amount of PEDOT: PSS is $1e^-7\,g/mm^3$ to $1e^-5\,g/mm^3$, based on the volume of the PEDOT: PSS doped foam.

6.  The piezoresistive pressure sensor according to any of the preceding claims, wherein the artificial leather layer is based on polyurethanes.

7.  The piezoresistive pressure sensor according to claim 1, wherein the open cell foam has a density, according to EN ISO 845, of below $20\,kg/m^3$, ; a compressive strength, according to EN ISO 3386-1, of more than 5 kPa; an open cell content of above 80 v%; and a resilience ratio of above 90%.

8.  The piezoresistive pressure sensor according to claim 1, wherein the open cell foam has a density, according to EN ISO 845, of above $70\,kg/m^3$ and below $500kg/m^3$; a compressive strength, according to EN ISO 3386-1, of more than 5 kPa; an open cell content of above 80 v%; and a resilience ratio of above 90%.

9.  The piezoresistive pressure sensor according to any of the preceding claims, wherein the continuous piezoresistive foam layer has a thickness of 1-15mm, a width of at least 50mm, and a ratio of length to width of (1-15) : 1, preferably (1-10) : 1, more preferably (1-5) : 1.

10. The piezoresistive pressure sensor according to any of the preceding claim, wherein distance between any of the edge of two neighbouring electrodes in an electrode set is in the range of 0.1 to 8 mm.

11. The piezoresistive pressure sensor according to claim 10, wherein the distance between two electrode sets is at least 2 times and no more than 10 times of the distance between any of the edge of two neighbouring electrodes in an electrode set.

12. The piezoresistive pressure sensor according to claim 1, wherein the artificial leather layer and the continuous piezoresistive foam layer, independently from each other, have translucency of higher than 3%.

13. The piezoresistive pressure sensor according to claim 12, wherein in the electrode array layer, each electrode in each electrode set is transparent electrode, such as transparent PEDOT: PSS electrode with Ag electrode line.

14. A control system, comprising a piezoresistive pressure sensor according to any of claims 1-13.

15. The control system according to claim 14, wherein the control system is used on dashboard, center console or middle console, or car horn.

16. A process for producing a piezoresistive pressure sensor according to any one of claims 1-13, comprising:

a) preparing an electrode array layer, and optionally integrating the electrode array layer to a cover layer; and
b) disposing a continuous piezoresistive foam layer on one side of an electrode array layer; **characterized in that** the piezoresistive pressure sensor further comprises
c) disposing an artificial leather layer directly on the continuous piezoresistive foam layer, wherein the continuous piezoresistive foam layer is made from conductive materials doped foam.

**Patentansprüche**

1. Piezoresistiver Drucksensor, der Folgendes umfasst:

eine ununterbrochene, piezoresistive Schaumstoffschicht, die durch Dotieren des Schaumstoffs mit leitfähigen Materialien hergestellt wird; und
eine Elektrodenanordnungsschicht, wobei auf einer ihrer Seiten die ununterbrochene, piezoresistive Schaumstoffschicht angeordnet ist;
**dadurch gekennzeichnet, dass** der piezoresistive Drucksensor ferner Folgendes umfasst:
eine Kunstlederschicht als Abdeckschicht, die direkt auf der ununterbrochenen, piezoresistiven Schaumstoffschicht angeordnet ist.

2. Piezoresistiver Drucksensor nach Anspruch 1, wobei die leitfähigen Materialien organische leitfähige Materialien mit einer Leitfähigkeit, die nicht kleiner als 1 mS/cm ist, sind.

3. Piezoresistiver Drucksensor nach einem der vorhergehenden Ansprüche, wobei das leitfähige Material PEDOT: PSS ist.

4. Piezoresistiver Drucksensor nach einem der vorhergehenden Ansprüche, wobei der Flächenwiderstand des ununterbrochenen, piezoresistiven Schaumstoffs ohne externen Druck auf mehr als 4G Ohm/mm eingestellt ist.

5. Piezoresistiver Drucksensor nach Anspruch 3, wobei die Dotiermenge des PEDOT: PSS im Bereich von $1 \cdot 10^{-7}$ g/mm$^3$ bis $1 \cdot 10^{-5}$ g/mm$^3$ auf der Grundlage des Volumens des mit dem PEDOT: PSS dotierten Schaumstoffs liegt.

6. Piezoresistiver Drucksensor nach einem der vorhergehenden Ansprüche, wobei die Kunstlederschicht auf Polyurethanen beruht.

7. Piezoresistiver Drucksensor nach Anspruch 1, wobei der offenzellige Schaumstoff eine Dichte gemäß EN ISO 845 von weniger als 20 kg/m$^3$; eine Druckfestigkeit gemäß EN ISO 3386-1 von mehr als 5 kPa; einen Offenzellengehalt von mehr als 80 Vol-%; und ein Resilienzverhältnis von mehr als 90 % aufweist.

8. Piezoresistiver Drucksensor nach Anspruch 1, wobei der offenzellige Schaumstoff eine Dichte gemäß EN ISO 845 von mehr als 70 kg/m$^3$ und weniger als 500 kg/m$^3$; eine Druckfestigkeit gemäß EN ISO 3386-1 von mehr als 5 kPa; einen Offenzellengehalt von mehr als 80 Vol-%; und ein Resilienzverhältnis von mehr als 90 % aufweist.

9. Piezoresistiver Drucksensor nach einem der vorhergehenden Ansprüche, wobei die ununterbrochene, piezoresistive Schaumstoffschicht eine Dicke von 1-15 mm, eine Breite von mindestens 50 mm und ein Verhältnis von Länge zu Breite von (1-15): 1, vorzugsweise (1-10): 1, stärker bevorzugt (1-5): 1 aufweist.

**10.** Piezoresistiver Drucksensor nach einem der vorhergehenden Ansprüche, wobei ein Abstand zwischen dem jeweiligen Rand von zwei benachbarten Elektroden in einer Elektrodengruppe im Bereich von 0,1 bis 8 mm liegt.

**11.** Piezoresistiver Drucksensor nach Anspruch 10, wobei der Abstand zwischen zwei Elektrodengruppen mindestens das 2-Fache und nicht mehr als das 10-Fache des Abstands zwischen dem jeweiligen Rand von zwei benachbarten Elektroden in einer Elektrodengruppe ist.

**12.** Piezoresistiver Drucksensor nach Anspruch 1, wobei die Kunstlederschicht und die ununterbrochene, piezoresistive Schaumstoffschicht unabhängig voneinander eine Lichtdurchlässigkeit von mehr als 3 % aufweisen.

**13.** Piezoresistiver Drucksensor nach Anspruch 12, wobei in der Elektrodenanordnungsschicht jede Elektrode in jeder Elektrodengruppe eine durchsichtige Elektrode wie etwa eine durchsichtige PEDOT: PSS-Elektrode mit einer Ag-Elektrodenleitung ist.

**14.** Steuersystem, das einen piezoresistiven Drucksensor nach einem der Ansprüche 1-13 umfasst.

**15.** Steuersystem nach Anspruch 14, wobei das Steuersystem auf einem Armaturenbrett, einer zentralen Konsole oder Mittelkonsole oder einer Kraftfahrzeughupe verwendet wird.

**16.** Prozess zum Herstellen eines piezoresistiven Drucksensors nach einem der Ansprüche 1-13, der Folgendes umfasst:

a) Vorbereiten einer Elektrodenanordnungsschicht und gegebenenfalls Integrieren der Elektrodenanordnungsschicht in eine Abdeckschicht; und
b) Anordnen einer ununterbrochenen, piezoelektrischen Schaumstoffschicht auf einer Seite einer Elektrodenanordnungsschicht; **dadurch gekennzeichnet, dass** der piezoresistive Drucksensor ferner Folgendes umfasst:
c) Anordnen einer Kunstlederschicht direkt auf der ununterbrochenen, piezoresistiven Schaumstoffschicht, wobei die ununterbrochene, piezoresistive Schaumstoffschicht aus einem mit leitfähigen Materialien dotierten Schaumstoff hergestellt wird.

**Revendications**

**1.** Capteur de pression piézorésistif comprenant :

une couche continue de mousse piézorésistive, qui est fabriquée en dopant la mousse avec des matériaux conducteurs ; et
une couche de réseau d'électrodes sur un côté de laquelle est disposée la couche de mousse piézorésistive continue ;
**caractérisé en ce que** le capteur de pression piézorésistif comprend en outre
une couche de cuir artificiel servant de couche de recouvrement, qui est disposée directement sur la couche continue de mousse piézorésistive.

**2.** Capteur de pression piézorésistif selon la revendication 1, dans lequel les matériaux conducteurs sont des matériaux conducteurs organiques dont la conductivité n'est pas inférieure à 1 mS/cm.

**3.** Capteur de pression piézorésistif selon l'une quelconque des revendications précédentes, dans lequel le matériau conducteur est un complexe PEDOT: PSS.

**4.** Capteur de pression piézorésistif selon l'une quelconque des revendications précédentes, dans lequel la résistance de surface de la mousse piézorésistive continue, sans aucune pression externe, est ajustée à plus de 4G Ohm/mm.

**5.** Capteur de pression piézorésistif selon la revendication 3, dans lequel la quantité de dopage du complexe PEDOT: PSS est de 1e^-7 g/mm$^3$ à 1e^-5 g/mm$^3$, sur la base du volume de mousse dopée en PEDOT: PSS.

**6.** Capteur de pression piézorésistif selon l'une quelconque des revendications précédentes, dans lequel la couche de cuir artificiel est à base de polyuréthanes.

7. Capteur de pression piézorésistif selon la revendication 1, dans lequel la mousse à cellules ouvertes a une densité, selon la norme EN ISO 845, inférieure à 20 kg/m$^3$, une résistance à la compression, selon la norme EN ISO 3386-1, supérieure à 5 kPa, une teneur en cellules ouvertes supérieure à 80 % en volume ; et un rapport de résilience supérieur à 90 %.

8. Capteur de pression piézorésistif selon la revendication 1, dans lequel la mousse à cellules ouvertes a une densité, selon la norme EN ISO 845, supérieure à 70 kg/m$^3$ et inférieure à 500 kg/m$^3$ ; une résistance à la compression, selon la norme EN ISO 3386-1, supérieure à 5 kPa ; une teneur en cellules ouvertes supérieure à 80 % en volume ; et un rapport de résilience supérieur à 90 %.

9. Capteur de pression piézorésistif selon l'une quelconque des revendications précédentes, dans lequel la couche continue de mousse piézorésistive a une épaisseur de 1 à 15 mm, une largeur d'au moins 50 mm, et un rapport de la longueur à la largeur de (1 à 15): 1, de préférence (1 à 10): 1, plus préférentiellement (1 à 5): 1.

10. Capteur de pression piézorésistif selon l'une quelconque des revendications précédentes, dans lequel la distance entre l'un quelconque des bords de deux électrodes voisines dans un ensemble d'électrodes se situe dans la plage s'étendant de 0,1 à 8 mm.

11. Capteur de pression piézorésistif selon la revendication 10, dans lequel la distance entre deux ensembles d'électrodes est au moins 2 fois et pas plus de 10 fois la distance entre l'un quelconque des bords de deux électrodes voisines dans un ensemble d'électrodes.

12. Capteur de pression piézorésistif selon la revendication 1, dans lequel la couche de cuir artificiel et la couche de mousse piézorésistive continue, indépendamment l'une de l'autre, ont une translucidité supérieure à 3 %.

13. Capteur de pression piézorésistif selon la revendication 12, dans lequel, dans la couche de réseau d'électrodes, chaque électrode de chaque ensemble d'électrodes est une électrode transparente, telle qu'une électrode transparente de PEDOT: PSS avec ligne d'électrode en Ag.

14. Système de commande, comprenant un capteur de pression piézorésistif selon l'une quelconque des revendications 1 à 13.

15. Système de commande selon la revendication 14, dans lequel le système de commande est utilisé sur le tableau de bord, la console centrale ou la console intermédiaire, ou l'avertisseur sonore d'une voiture.

16. Procédé de fabrication d'un capteur de pression piézorésistif selon l'une quelconque des revendications 1-13, le procédé comprenant les étapes suivantes :

   a) préparer une couche de réseau d'électrodes, et éventuellement intégrer la couche de réseau d'électrodes à une couche de recouvrement ; et
   b) disposer une couche continue de mousse piézorésistive sur un côté d'une couche de réseau d'électrodes ; **caractérisé en ce que** le capteur de pression piézorésistif comprend en outre
   c) de disposer une couche de cuir artificiel directement sur la couche continue de mousse piézorésistive, la couche continue de mousse piézorésistive étant constituée de mousse dopée de matériaux conducteurs.

Figure 1.1

Figure 1.2

Cover layer
(one sided electrode array
on bottom side of cover layer)

PEDOT:PSS doped
open cell melamine
foam

Figure 2

Figure 3.1

Figure 3.2

Figure 3.3

Upper-left    upper    Upper-right

left

Bottom-left

Bottom    Bottom-right    right

Figure 4

Figure 5

Figure 6

Figure 7

Figure 8

Poly Urethane Cover Layer

Haptex adhesive layer

Fabric layer for base layer

Artificial leather Haptex®

EP 4 168 764 B1

Figure 9

Figure 10

Figure 11

EP 4 168 764 B1

Figure 12

Figure 13

Figure 14

Figure 15

**EP 4 168 764 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170199095 A1
- WO 2018013557 A1
- US 20170057409 A1
- US 9254786 B2
- EP 0823124 A1
- WO 9927550 A1
- WO 9713130 A2
- US 2016340534 A1
- US 2014215850 A1